# EUROPEAN PATENT APPLICATION

(11) **EP 4 726 408 A1**
(43) Date of publication of application: **15.04.2026**
(21) Application number: 23940365.2
(22) Date of filing: 19.09.2023
(51) Int. Cl.: G01R 31/378

(54) **INSULATION IMPEDANCE MEASUREMENT CIRCUIT AND ENERGY STORAGE CONVERSION SYSTEM**

(30) Priority: 07.06.2023 CN 202321451351 U
(71) Applicant: Sungrow Power Supply Co., Ltd., Hefei, Anhui 230088 (CN)
(72) Inventor: ZHENG, Feiyang, Hefei, Anhui 230088 (CN); LI, Le, Hefei, Anhui 230088 (CN); DENG, Kai, Hefei, Anhui 230088 (CN); ZHOU, Jie, Hefei, Anhui 230088 (CN)
(74) Representative: Zacco Norway AS
(86) International application number: PCT/CN2023/119676
(87) International publication number: WO 2024/250487

(57) **Abstract**

Disclosed in the present utility model are an insulation impedance measurement circuit and an energy storage conversion system. The insulation impedance measurement circuit comprises a plurality of positive electrode branches, a negative electrode branch, an insulation impedance measurement module and a power conversion module, wherein the plurality of positive electrode branches are each connected to a positive electrode of a corresponding battery pack and the power conversion module; the negative electrode branch is connected to negative electrodes of all the battery packs and the power conversion module; each positive electrode branch comprises a first contactor, and the negative electrode branch comprises a second contactor; and the insulation impedance measurement module is connected to the power conversion module and the negative electrode branch, and the insulation impedance measurement module is used for measuring the insulation impedance of a plurality of branches. The present utility model can simplify the circuit structure and reduce costs.

## Description

This application claims the priority to Chinese Patent Application No. 2023214513515, titled "INSULATION IMPEDANCE MEASUREMENT CIRCUIT AND ENERGY STORAGE CONVERSION SYSTEM", filed on June 7, 2023 with the China National Intellectual Property Administration, which is incorporated herein by reference in its entirety.

### FIELD

The present disclosure relates to the technical field of insulation detection, and in particular to an insulation impedance detection circuit and an energy storage conversion system.

### BACKGROUND

In an energy storage conversion system, the primary function of a converter is to manage the charging and discharging of batteries in the energy storage system. Before operation of the converter, it should be first ensured that the battery-side impedance to ground of the converter meets the requirements. Currently, the converter employs an insulation impedance detection circuit to detect the insulation impedance of the energy storage system.

In a multi-branch input energy storage converter, each branch is correspondingly provided with an energy pack, for example, the energy pack may be a battery pack. Multiple branches charge and discharge simultaneously, necessitating insulation detection for battery packs corresponding to the multiple branches. To ensure personnel safety and normal operation of the machine, it is typically required to perform insulation detection on the battery before starting and after shutting down the machine. However, conventional detection solutions have the defects of high costs and complex circuit control.

### SUMMARY

An insulation impedance detection circuit and an energy storage conversion system are provided according to the present disclosure, simplifying the circuit structure and reducing costs.

According to an aspect of the present disclosure, an insulation impedance detection circuit is provided. The insulation impedance detection circuit includes multiple positive branches, a negative branch, an insulation impedance detection module, and a power conversion module.

Each of the multiple positive branches is connected between a positive electrode of a corresponding battery pack of all battery packs and the power conversion module, the negative branch is connected between negative electrodes of all the battery packs and the power conversion module, each of the multiple positive branches includes a first contactor, and the negative branch includes a second contactor.

The insulation impedance detection module is connected to the power conversion module and the negative branch, and is configured for detecting insulation impedances of multiple branches.

In an embodiment, first terminals of the multiple first contactors are connected to the positive electrodes of all the battery packs in one-to-one correspondence, second terminals of the multiple first contactors are connected to a first terminal of the power conversion module.

A first terminal of the second contactor is connected to the negative electrodes of all the battery packs, and a second terminal of the second contactor is connected to a second terminal of the power conversion module.

In an embodiment, at least one positive branch of the multiple positive branches includes a soft-start unit, and the soft-start unit is connected in parallel with the first contactor in the at least one positive branch.

In an embodiment, the soft-start unit includes a first switch and a soft-start resistor, a first terminal of the first switch is connected to a first terminal of the first contactor in the at least one positive branch, a second terminal of the first switch is connected to a first terminal of the soft-start resistor, and a second terminal of the soft-start resistor is connected to a second terminal of the first contactor in the at least one positive branch.

In an embodiment, each of the multiple positive branches includes a first fuse, a first terminal of the first fuse is connected to the positive electrode of the corresponding battery pack, and a second terminal of the first fuse is connected to the first terminal of the first contactor in the positive branch.

In an embodiment, the negative branch includes a second fuse, a first terminal of the second fuse is connected to a negative electrode of a corresponding battery pack, and a second terminal of the second fuse is connected to the first terminal of the second contactor.

In an embodiment, the insulation impedance detection circuit further includes a filtering module, where the filtering module is connected between a first terminal of the power conversion module and a second terminal of the power conversion module.

In an embodiment, the filtering module includes a bus capacitor.

In an embodiment, the insulation impedance detection module includes a first resistor, a second resistor, a third resistor, and a second switch.

A first terminal of the first resistor is connected to a second terminal of the first contactor, a second terminal of the first resistor is connected to a first terminal of the third resistor, a first terminal of the second resistor, and a first terminal of the second switch, a second terminal of the third resistor is grounded, and a second terminal of the second resistor is connected to a second terminal of the second switch and a first terminal of the second contactor.

According to another aspect of the present disclosure, an energy storage conversion system is provided. The energy storage conversion system includes multiple battery packs, and the insulation impedance detection circuit according the aforementioned aspect.

The technical solutions of the embodiments of the present disclosure simplify the circuit structure, optimize the control process, and reduce the spatial requirements for insulation impedance detection. Compared with the related art, this solution does not require soft-start circuits or multiple switches, resulting in simple control logic and low costs. In summary, the issues of high costs and complex circuit control in the related art are addressed according to the present disclosure.

It should be understood that the content described in this section is neither intended to identify keys or important features of the embodiments of the present disclosure nor to limit the scope of the present disclosure. Other features of the present disclosure are to be readily understandable through the following specification.

### BRIEF DESCRIPTION OF THE DRAWINGS

For clearer illustration of the technical solutions according to embodiments of the present disclosure, drawings required in descriptions of the embodiments are briefly described below. Apparently, the drawings in the following descriptions only illustrate some of embodiments of the present disclosure, and other drawings may be obtained by those skilled in the art based on the provided drawings without creative efforts.
FIG. 1 is a schematic diagram of an insulation impedance detection circuit according to an embodiment of the present disclosure;
FIG. 2 is a schematic diagram of an insulation impedance detection circuit according to another embodiment of the present disclosure;
FIG. 3 is a schematic diagram of an insulation impedance detection circuit according to another embodiment of the present disclosure; and
FIG. 4 is a schematic diagram of an insulation impedance detection circuit according to another embodiment of the present disclosure.

### DETAILED DESCRIPTION

In order to enable those skilled in the art to better understand the solutions according to the present disclosure, the technical solutions in the embodiments of the present disclosure are described clearly and completely hereinafter with reference to the drawings in the embodiments of the present disclosure. It is apparent that the embodiments described are only some rather than all the embodiments of the present disclosure. All other embodiments obtained by those skilled in the art based on the embodiments in the present disclosure without creative efforts shall fall within the protection scope of the present disclosure.

It should be noted that, the terms such as "first" and "second" in the specification, the claims and the drawings of the present disclosure are intended to distinguish between similar objects, but are not necessarily used for describing a specific sequence or a precedence order. It should be understood that the terms used in such a way are interchangeable in proper circumstances, so that the embodiments of the present disclosure described herein can be implemented in orders other than the order illustrated or described herein. Moreover, the terms "include", "have" and any other variants thereof are intended to cover a non-exclusive inclusion. For example, a process, method, system, product, or device that includes a list of steps or units is not necessarily limited to the expressly listed steps or units, but may include other steps or units not expressly listed or inherent to the process, method, product, or device.

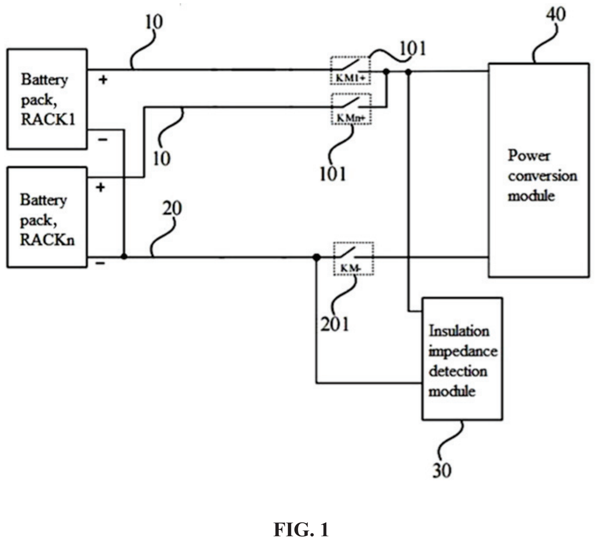

FIG. 1 is a schematic diagram of an insulation impedance detection circuit according to an embodiment of the present disclosure. Referring to FIG. 1, according to an aspect of the present disclosure, an insulation impedance detection circuit is provided. The insulation impedance detection circuit includes multiple positive branches 10, a negative branch 20, an insulation impedance detection module 30, and a power conversion module 40. Each of the multiple positive branches 10 is connected between a positive electrode "+" of a corresponding battery pack of all battery packs and the power conversion module 40, and the negative branch 20 is connected between negative electrodes "-" of all the battery packs and the power conversion module 40. Each of the multiple positive branches 10 includes a first contactor 101, and the negative branch 20 includes a second contactor 201. The insulation impedance detection module 30 is connected to the power conversion module 40 and the negative branch 20, and is configured for detecting insulation impedances of multiple branches.

In an embodiment, first terminals of the multiple positive branches 10 are connected to the positive electrodes "+" of all the battery packs in one-to-one correspondence. Second terminals of the multiple positive branches 10 are connected to a first terminal of the power conversion module 40. A first terminal of the negative branch 20 is connected to the negative electrodes "-" of all the battery packs, and a second terminal of the negative branch 20 is connected to a second terminal of the power conversion module 40. The first contactor 101 is connected between the positive electrode "+" of the corresponding battery pack and the first terminal of the power conversion module 40. The second contactor 201 is connected between the negative electrodes "-" of all the battery packs and the second terminal of the power conversion module 40. A first terminal of the insulation impedance detection module 30 is connected to the first terminal of the power conversion module 40, and a second terminal of the insulation impedance detection module 30 is connected to the negative branch 20.

The first contactor 101 may be a positive main contactor, and each of the multiple positive branches 10 is provided with a positive main contactor. For example, a main contactor of a first positive branch is a first positive main contactor KM1+, and a main contactor of an nth positive branch is an nth positive main contactor KMn+. The second contactor 201 may be a negative main contactor KM-.

The insulation impedance detection process is as follows. When a machine is powered on for the first time, a startup instruction is issued. In this case, it is determined whether any of the first contactors 101 are stuck, so as to avoid impact on a bus capacitor during insulation detection. When it is determined that the first contactors 101 are normal, for detecting an insulation impedance of the first positive branch, the first positive main contactor KM1+ is closed to perform insulation impedance detection on the first positive branch. For detecting an insulation impedance of a second positive branch, a second positive main contactor KM2+ is closed to perform insulation impedance detection on the second positive branch.

After the machine is shut down, insulation impedance detection is performed at time intervals. Before the first detection after shutdown, it is determined whether any of the first main contactors 101 are stuck. If the determination result is normal, the first positive main contactor KM1+ is closed, and then the insulation impedance of the first positive branch is detected. The second positive main contactor KM2+ is closed, and then the insulation impedance of the second positive branch is detected.

The insulation impedance detection module 30 is connected to a converged circuit of the multiple branches. The main contactors of the multiple branches are alternately closed to detect insulation impedance values of all branches. The insulation impedance detection circuits share a common negative branch, reducing transmission costs.

The technical solutions of the embodiments of the present disclosure simplify the circuit structure, optimize the control process, and reduce the spatial requirements for insulation impedance detection. Compared with the related art, this solution does not require soft-start circuits or multiple switches, resulting in simple control logic and low costs. In summary, the issues of high costs and complex circuit control in the related art are addressed according to the present disclosure.

Referring to FIG. 1, in an embodiment, first terminals of the first contactors 101 are connected to the positive electrodes "+" of the battery pack in one-to-one correspondence, and second terminals of the first contactors 101 are connected to the first terminal of the power conversion module 40. A first terminal of the second contactor 201 is connected to the negative electrodes "-" of all the battery packs, and a second terminal of the second contactor 201 is connected to the second terminal of the power conversion module 40.

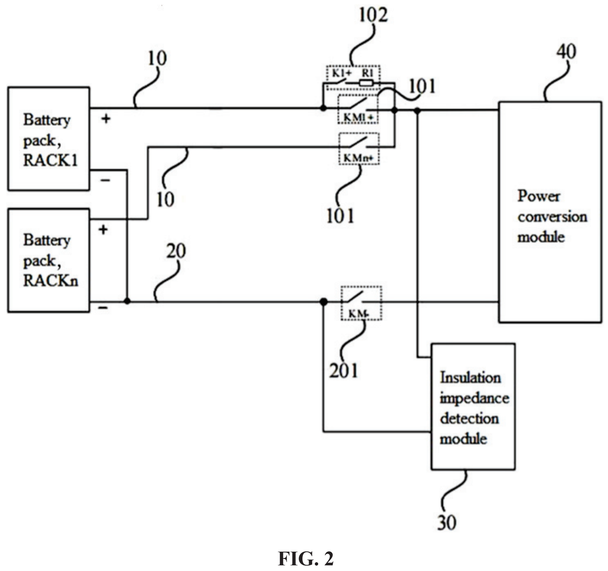

FIG. 2 is a schematic diagram of an insulation impedance detection circuit according to another embodiment of the present disclosure. Referring to FIG. 2, in an embodiment, at least one positive branch 10 of the multiple positive branches includes a soft-start unit 102, and the soft-start unit 102 is connected in parallel with the first contactor 101 in the least one positive branch 10.

Referring to FIG. 2, in an embodiment, the soft-start unit 102 includes a first switch K1 and a soft-start resistor R1. A first terminal of the first switch K1 is connected to a first terminal of the first contactor 101 in the at least one positive branch 10, a second terminal of the first switch K1 is connected to a first terminal of the soft-start resistor R1, and a second terminal of the soft-start resistor R1 is connected to a second terminal of the first contactor 101 in the at least one positive branch 10.

In an embodiment, the soft-start unit 102 is connected in parallel with the first contactor 101, and is configured for achieving a soft-start function during normal operation.

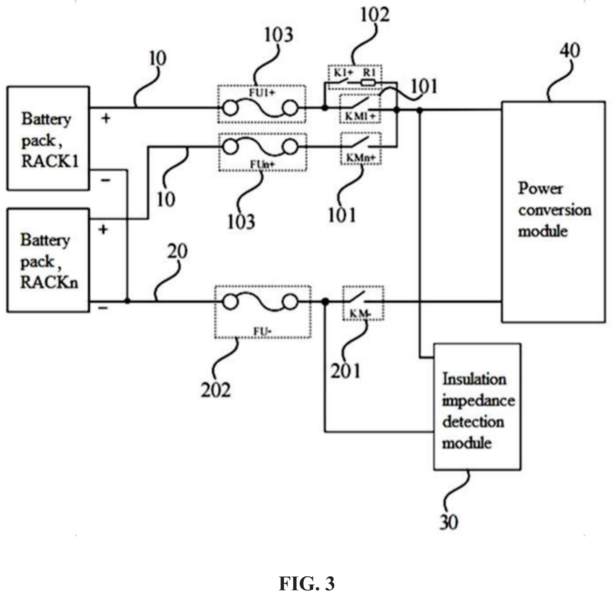

FIG. 3 is a schematic diagram of an insulation impedance detection circuit according to another embodiment of the present disclosure. Referring to FIG. 3, in an embodiment, each of the multiple positive branches 10 includes a first fuse 103. A first terminal of the first fuse 103 is connected to the positive electrode "+" of the corresponding battery pack, and a second terminal of the first fuse 103 is connected to the first terminal of the first contactor 101 in the positive branch 10.

Referring to FIG. 3, in an embodiment, the negative branch 20 includes a second fuse 202. A first terminal of the second fuse 202 is connected to a negative electrode "-" of a corresponding battery pack, and a second terminal of the second fuse 202 is connected to the first terminal of the second contactor 201.

In an embodiment, one terminal of the first fuse 103 is connected to the positive electrode "+" of the corresponding battery pack, and the other terminal of the first fuse 103 is connected to the first terminal of the power conversion module 40 via the first contactor 101. One terminal of the second fuse 202 is connected to the negative electrodes "-" of all the battery packs, and the other terminal of the second fuse 202 is connected to the second terminal of the power conversion module 40 via the second contactor 201.

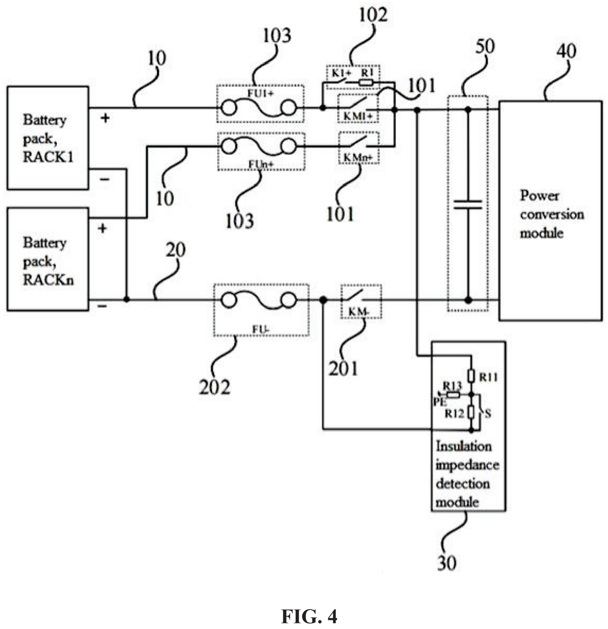

FIG. 4 is a schematic diagram of an insulation impedance detection circuit according to another embodiment of the present disclosure. Referring to FIG. 4, in an embodiment, the insulation impedance detection circuit further includes a filtering module 50. The filtering module 50 is connected between a first terminal of the power conversion module 40 and a second terminal of the power conversion module 40.

Referring to FIG. 4, in an embodiment, the filtering module 50 includes a bus capacitor.

In an embodiment, the bus capacitor is primarily configured for providing reactive voltage support.

Referring to FIG. 4, in an embodiment, the insulation impedance detection module 30 includes a first resistor R11, a second resistor R12, a third resistor R13, and a second switch S. A first terminal of the first resistor R11 is connected to a second terminal of the first contactor 101. A second terminal of the first resistor R11 is connected to a first terminal of the third resistor R13, a first terminal of the second resistor R12, and a first terminal of the second switch S. A second terminal of the third resistor R13 is grounded, that is, being connected to PE. A second terminal of the second resistor R12 is connected to a second terminal of the second switch S and a first terminal of the second contactor 201.

In an embodiment, the insulation impedance detection module 30 may be a single-switch Y-type unbalanced bridge insulation impedance detection circuit, including: the second switch S and a Y-type bridge arm formed by the first resistor R11, the second resistor R12, and the third resistor R13. One terminal of the Y-type bridge arm is connected to a positive electrode "+" of a corresponding battery pack, another terminal is connected to a negative electrode "-" of the battery pack, and a third terminal is grounded (Protecting Earthing, PE). The second switch S is connected between a midpoint of the Y-type bridge arm and the negative electrode "-" of the battery pack.

During each insulation impedance detection, by controlling the turning on and off of the second switch S, voltage detection results before and after the turning on and off of the second switch S are obtained. An impedance value R+ between the positive electrode "+" of the battery pack and PE, and an impedance value R- between the negative electrode "-" of the battery pack and PE are calculated, so as to determine whether the battery pack of the branch meets the insulation impedance requirements.

An energy storage conversion system is provided according to the present disclosure. The energy storage conversion system includes multiple battery packs and the insulation impedance detection circuit according to the embodiments of the present disclosure.

Since the energy storage conversion system includes the insulation impedance detection circuit according to the embodiments of the present disclosure, the beneficial effects of the energy storage conversion system are the same as those of the insulation impedance detection circuit and will not be repeated herein.

The above specific embodiments are not intended to limit the protection scope of the present disclosure. It should be understood by those skilled in the art that various modifications, combinations, sub combinations and substitutions may be made based on design requirements and other factors. Any modification, equivalent and improvement made according to the spirit and principle of the present disclosure shall be included within the protection scope of the present disclosure.

## Claims

1. An insulation impedance detection circuit, **characterized by** comprising:
a plurality of positive branches;
a negative branch;
an insulation impedance detection module; and
a power conversion module, wherein
each of the plurality of positive branches is connected between a positive electrode of a corresponding battery pack of all battery packs and the power conversion module, the negative branch is connected between negative electrodes of all the battery packs and the power conversion module, each of the plurality of positive branches comprises a first contactor, and the negative branch comprises a second contactor; and
the insulation impedance detection module is connected to the power conversion module and the negative branch, and is configured for detecting insulation impedances of a plurality of branches.

2. The insulation impedance detection circuit according to claim 1, wherein first terminals of the plurality of first contactors are connected to the positive electrodes of all the battery packs in one-to-one correspondence, second terminals of the plurality of first contactors are connected to a first terminal of the power conversion module; and
a first terminal of the second contactor is connected to the negative electrodes of all the battery packs, and a second terminal of the second contactor is connected to a second terminal of the power conversion module.

3. The insulation impedance detection circuit according to claim 1, wherein at least one positive branch of the plurality of positive branches comprises a soft-start unit, and the soft-start unit is connected in parallel with the first contactor in the at least one positive branch.

4. The insulation impedance detection circuit according to claim 3, wherein the soft-start unit comprises a first switch and a soft-start resistor, a first terminal of the first switch is connected to a first terminal of the first contactor in the at least one positive branch, a second terminal of the first switch is connected to a first terminal of the soft-start resistor, and a second terminal of the soft-start resistor is connected to a second terminal of the first contactor in the at least one positive branch.

5. The insulation impedance detection circuit according to claim 2, wherein each of the plurality of positive branches comprises a first fuse, a first terminal of the first fuse is connected to the positive electrode of the corresponding battery pack, and a second terminal of the first fuse is connected to the first terminal of the first contactor in the positive branch.

6. The insulation impedance detection circuit according to claim 2, wherein the negative branch comprises a second fuse, a first terminal of the second fuse is connected to a negative electrode of a corresponding battery pack, and a second terminal of the second fuse is connected to the first terminal of the second contactor.

7. The insulation impedance detection circuit according to claim 1, further comprising:
a filtering module, wherein
the filtering module is connected between a first terminal of the power conversion module and a second terminal of the power conversion module.

8. The insulation impedance detection circuit according to claim 7, wherein the filtering module comprises a bus capacitor.

9. The insulation impedance detection circuit according to claim 1, wherein the insulation impedance detection module comprises a first resistor, a second resistor, a third resistor, and a second switch, wherein
a first terminal of the first resistor is connected to a second terminal of the first contactor, a second terminal of the first resistor is connected to a first terminal of the third resistor, a first terminal of the second resistor, and a first terminal of the second switch, a second terminal of the third resistor is grounded, and a second terminal of the second resistor is connected to a second terminal of the second switch and a first terminal of the second contactor.

10. An energy storage conversion system, **characterized by** comprising:
a plurality of battery packs; and
the insulation impedance detection circuit according to any one of claims 1 to 9.
